# EUROPEAN PATENT APPLICATION

(11) **EP 0 911 874 A2**
(43) Date of publication of application: **28.04.1999**
(21) Application number: 98120024.9
(22) Date of filing: 22.10.1998
(51) Int. Cl.: H01L 21/60, H01L 21/56

(54) **Management of a lateral deflection amount of a metal wire in a semiconductor device**

(30) Priority: 22.10.1997 JP 289331/97
(71) Applicant: NEC CORPORATION, Tokyo (JP)
(72) Inventor: Inaba, Takehito, c/o NEC Corporation, Tokyo (JP)
(74) Representative: Betten & Resch

(57) **Abstract**

In a semiconductor device, a bus bar (4a) is provided with a projection (9a). Based on a positional relationship between the projection and a metal wire (13a) subjected to the lateral deflection upon resin filling, the metal wire lateral deflection amount is managed. The projection may be provided on a suspension pin or at another portion of a lead frame. A cutout may be provided instead of the projection.

## Description

### Background of the Invention:

The present invention relates to a semiconductor device and, in particular, to a lead frame of the semiconductor device and relates to a managing method of managing a metal wire used in the semiconductor device.

Such a metal wire is connected between a lead frame and a semiconductor element known in the art. It is assumed that the metal wire has a lateral deflection amount upon resin filling of the semiconductor device. Therefore, it is necessary to manage the lateral deflection amount of the metal wire.

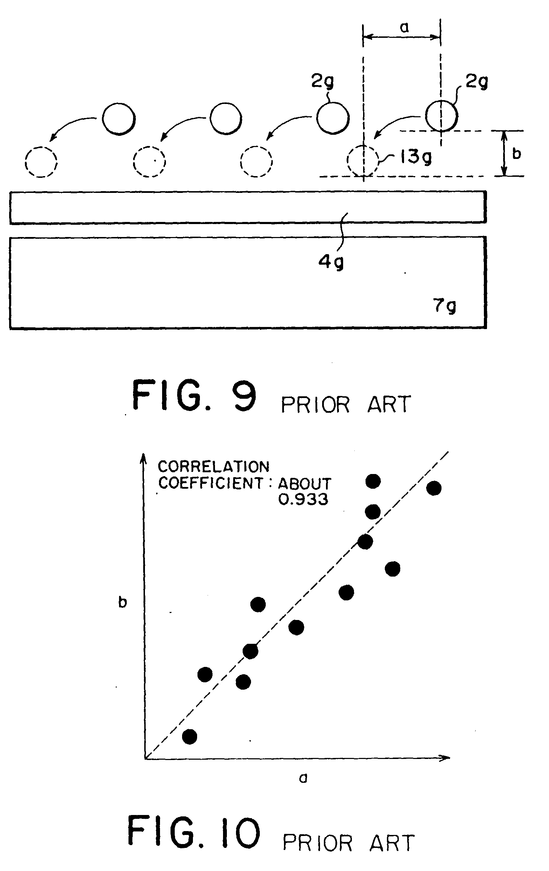

Furthermore, necessity for managing the lateral deflection amount of the metal wire upon resin filling will be explained with reference to Figs. 9 to 14.

There has been a problem of the metal wire lateral deflection which occurs upon resin filling in the course of producing a semiconductor device. When the metal wire lateral deflection occurs upon resin filling, a short circuit may occur between adjacent metal wires 2g or between a metal wire 2g and an inner lead 3g.

If an interval between the metal wires 2g and an interval between the metal wire 2g and the inner lead 3g before resin filling are designed to be sufficiently large, even if the metal wire lateral deflection occurs upon resin filling, the short circuit between the metal wires 2g or between the metal wire 2g and the inner lead 3g does not occur.

However, when the lateral deflection of the metal wire 2g occurs, stresses are applied to a junction between the metal wire 2g and an electrode 1g formed on a semiconductor element 7g and a junction between the metal wire 2g and the inner lead 3g so that the joining strength at those portions is reduced. Therefore, the metal wire is liable to be cut due to external stresses caused by a temperature cycle or the like. As a countermeasure, it is necessary to manage a lateral deflection amount a (Fig. 9) of the metal wire.

In case of a semiconductor device employing the overlead bonding wherein bus bars 4g are provided and the metal wires 2g pass over the corresponding bus bars 4g, it is not possible to observe three-dimensionally an interval between the metal wire 2g and the bus bar 4g by means of a two-dimensional non-destructive inspection method using X-rays or the like. Therefore, a metal wire vertical deflection amount b (Fig. 9) is managed based on a correlation (Fig. 10) between the metal wire lateral deflection amount a and the metal wire vertical deflection amount b. Thus, the management of the metal wire lateral deflection amount is particularly important.

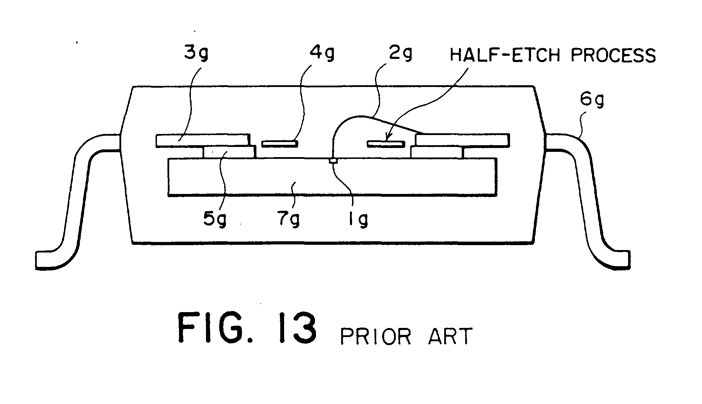

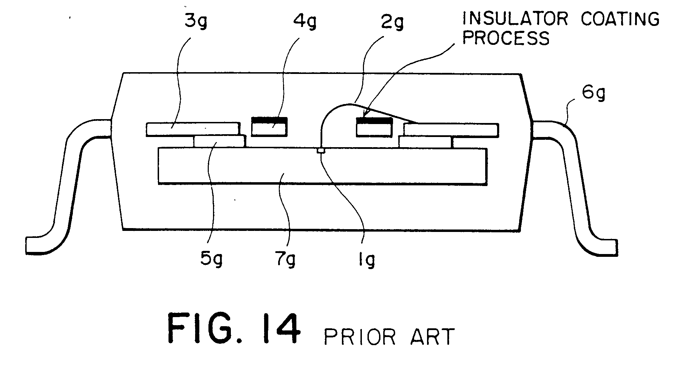

When not carrying out the management based on the foregoing correlation, a technique has been used, wherein a half-etch process is applied to the bus bars 4g to ensure a long interval between the metal wire 2g and the corresponding bus bar 4g as shown in Fig. 13, or an insulator coating process is applied to the bus bars 4g to avoid a short circuit between the metal wire 2g and the corresponding bus bar 4g as shown in Fig. 14.

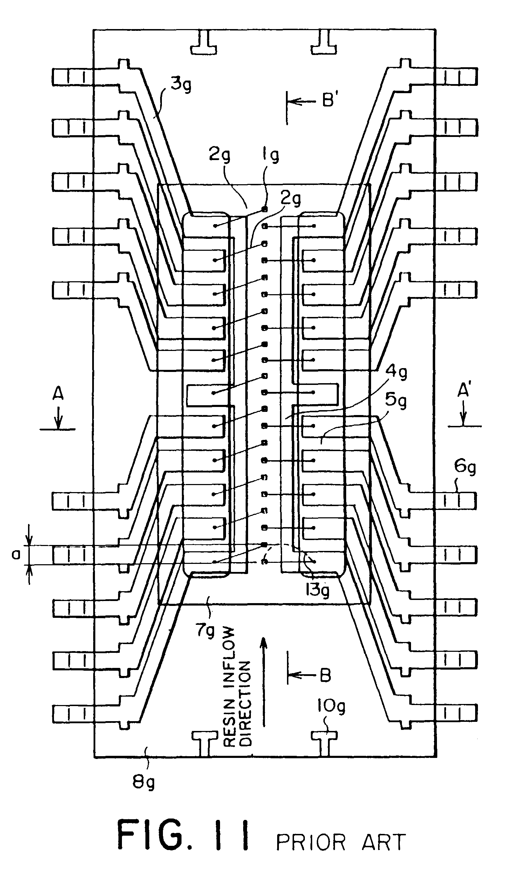

Now, the structures of conventional semiconductor devices will be explained with reference to Figs. 11, 12 and 15.

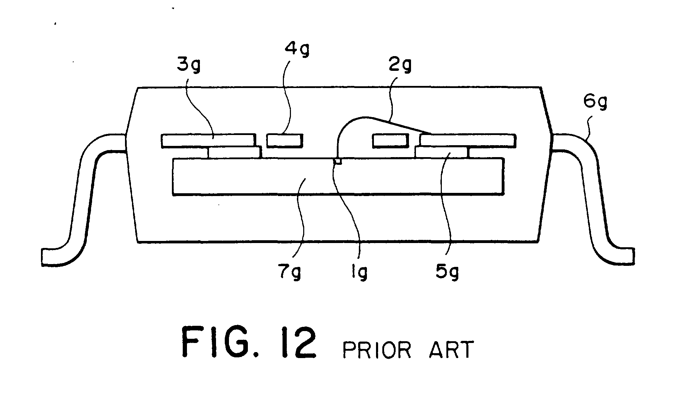

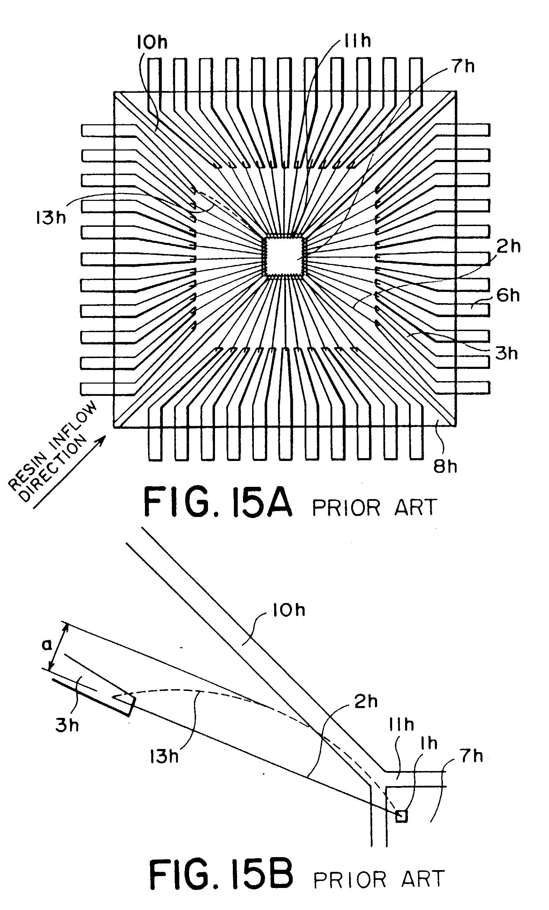

Fig. 11 is a plan-perspective view of a semiconductor device using the overlead bonding. Fig. 12 is a sectional view taken along the line A-A' in Fig. 11. Fig. 15A is a plan-perspective view of a semiconductor device of a normal structure using no bus bar. Fig. 15B is an enlarged view of the main part of the semiconductor device shown in Fig. 15A.

First, the structure of the semiconductor device using the overlead bonding will be explained with reference to Figs. 11 and 12.

In Fig. 11, the electrodes 1g are aligned at the center of the semiconductor element 7g. Tip portions of the inner leads 3g are fixed on the semiconductor element 7g by adhesive tapes 5g. Each of the bus bars 4g is disposed between the electrodes 1g and the tip portions of the corresponding inner leads 3g. The electrodes 1g and the tip portions of the inner leads 3g are connected by the metal wires 2g, respectively. As shown in Fig. 12, the metal wires 2g pass over the corresponding bus bars 4g.

In the semiconductor device thus structured, it is known that a metal wire, whose lateral deflection amount becomes the greatest upon resin filling, extends perpendicularly to a resin inflow direction and is located near a resin inlet (not shown). Specifically, in Fig. 11, the metal wire lateral deflection amount a of a metal wire 13g identified by a dotted line becomes the greatest and thus it is necessary to manage the lateral deflection amount of the metal wire 13g.

Now, the semiconductor device of the normal structure will be explained with reference to Figs. 15A and 15B.

In the figures, electrodes 1h are arranged along the peripheral edges of a semiconductor element 7h. The semiconductor element 7h is fixed on a semiconductor element mounting portion 11h using a mount material (not shown) such as silver paste. The semiconductor element mounting portion 11h is connected to outer portions (not shown) of a lead frame by suspension pins 10h. The electrodes 1h provided on the semiconductor element 7h are connected to inner leads 3h via metal wires 2h, respectively.

In the semiconductor device thus structured, it is known that a metal wire, whose lateral deflection amount becomes the greatest upon resin filling, extends perpendicularly to a resin inflow direction and is located near a resin inlet (not shown). Specifically, in Figs. 15A and 15B, the metal wire lateral deflection amount a of a metal wire 13h identified by a dotted line becomes the greatest and thus it is necessary to manage the lateral deflection amount of the metal wire 13h.

Now, a conventional method of measuring the metal wire lateral deflection amount will be explained.

First, on an image displayed on a monitor of an X-ray inspection apparatus connected to an image processing device, a reference line segment is drawn by connecting the junction between the metal wire 2g and the electrode 1g and the junction between the metal wire 2g and the inner lead 3g. Then, a line segment parallel to the reference line segment is drawn so as to pass a point of the maximum lateral deflection of the metal wire. Thereafter, an interval between the reference line segment and the line segment parallel thereto is derived by comparison with a reference object displayed on the monitor, as the relative lateral deflection amount a of the metal wire.

However, the following problems exist in the conventional technique:

The first problem is that the measurement of the metal wire lateral deflection amount takes much time. The reason for this is that the measuring method of the metal wire lateral deflection amount is complicated as described above. Specifically, on the image displayed on the monitor of the X-ray inspection apparatus connected to the image processing device, the reference line segment is first drawn by connecting the junction between the metal wire and the electrode and the junction between the metal wire and the inner lead. Then, the line segment parallel to the reference line segment is drawn so as to pass the point of the maximum lateral deflection of the metal wire. Thereafter, the interval between the reference line segment and the line segment parallel thereto is derived by comparison with the reference object displayed on the monitor, as the relative lateral deflection amount a of the metal wire.

The second problem is that the management of the metal wire lateral deflection can not be carried out automatically. The reason for this is that the measuring method of the metal wire lateral deflection amount is complicated as described above, and that the points necessary for the measurement, such as the junction between the metal wire and the electrode, the junction between the metal wire and the inner lead, and the maximum lateral deflection point of the metal wire, can not be automatically recognized using an automatic recognition apparatus.

### Summary of the Invention:

It is therefore an object of the present invention to provide a lead frame of a semiconductor device which makes it possible to automatically manage the metal wire lateral deflection amount.

It is another object of the present invention to provide a lead frame of a semiconductor device which makes it possible to judge without measuring the metal wire lateral deflection amount whether or not the amount is within a given range.

It is another object of the present invention to provide a managing method which can improve productivity by automating management of the metal wire lateral deflection.

Other objects of the present invention will become clear as the description proceeds.

A lead frame to which the present invention is applicable is for use in a semiconductor device comprising a semiconductor element and a metal wire which is connected between the semiconductor element and the lead frame. In the lead frame, the lead frame comprises managing means for managing a lateral deflection amount of the metal wire.

A semiconductor device to which the present invention is applicable comprises a semiconductor element, a lead frame, and a metal wire which is connected between the semiconductor element and the lead frame. In the semiconductor device, the lead frame comprises managing means for managing a lateral deflection amount of the metal wire.

A managing method to which the present invention is applicable is of managing a metal wire connected between a semiconductor element and a lead frame which are included in a semiconductor device. The managing method comprises the steps of providing managing means at a portion of the lead frame and of managing a lateral deflection amount of the metal wire by the use of the managing means.

### Brief Description of the Drawing:

Fig. 1 is a plan-perspective view showing a semiconductor device according to a first preferred embodiment of the present invention;
Fig. 2A is a diagram for explaining a managing method of the metal wire lateral deflection amount in the semiconductor device shown in Fig. 1;
Fig. 2B is a diagram for explaining a managing method of the metal wire lateral deflection amount according to a modification of the first preferred embodiment;
Fig. 3A is a plan-perspective view showing a semiconductor device according to a second preferred embodiment of the present invention;
Fig. 3B is an enlarged view of the main part of the semiconductor device shown in Fig. 3A;
Fig. 4 is a plan-perspective view showing a semiconductor device according to a third preferred embodiment of the present invention;
Fig. 5 is a plan-perspective view showing a semiconductor device according to a fourth preferred embodiment of the present invention;
Fig. 6A is a diagram for explaining a managing method of the metal wire lateral deflection amount in the semiconductor device shown in Fig. 5;
Fig. 6B is a diagram for explaining a managing method of the metal wire lateral deflection amount according to a modification of the fourth preferred embodiment;
Fig. 7A is a plan-perspective view showing a semiconductor device according to a fifth preferred embodiment of the present invention;
Fig. 7B is an enlarged view of the main part of the semiconductor device shown in Fig. 7A;
Fig. 8 is a plan-perspective view showing a semiconductor device according to a sixth preferred embodiment of the present invention;
Fig. 9 is a sectional view taken along the line B-B' in Fig. 11;
Fig. 10 is a diagram showing a correlation between metal wire lateral deflection amount a and metal wire vertical deflection amount b shown in Fig. 9;
Fig. 11 is a plan-perspective view showing a conventional semiconductor device;
Fig. 12 is a sectional view taken along the line A-A' in Fig. 11;
Fig. 13 is a sectional view taken along the line A-A' in Fig. 11, wherein a half-etch process is applied to bus bars;
Fig. 14 is a sectional view taken along the line A-A' in Fig. 11, wherein an insulator coating process is applied to bus bars;
Fig. 15A is a plan-perspective view showing another conventional semiconductor device; and
Fig. 15B is an enlarged view of the main part of the semiconductor device shown in Fig. 15A.

### Description of the Preferred Embodiments:

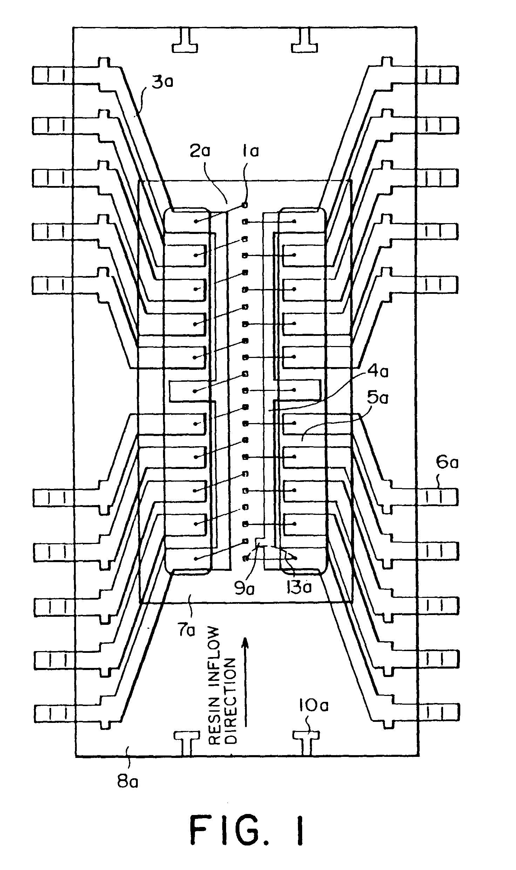

Now, preferred embodiments of the present invention will be described hereinbelow with reference to Figs. 1 to 8.

Fig. 1 shows a semiconductor device according to the first preferred embodiment of the present invention. The shown semiconductor device employs the overlead bonding in which bus bars 4a are provided in the manner known in the art and which metal wires 2a pass over the corresponding bus bars 4a, respectively. Electrodes 1a are aligned at the center of a semiconductor element 7a. Tip portions of inner leads 3a are fixed on the semiconductor element 7a by adhesive tapes 5a made of polyimide or the like and having a thickness of about 0.05mm to 0.1mm. The electrodes 1a and the tip portions of the inner leads 3a are connected to each other via the metal wires 2a, respectively. Each metal wire 2a is made of gold or an alloy of gold and has a diameter of about 20 µm to 30 µm. Each of the bus bars 4a is disposed between the electrodes 1a and the tip portions of the corresponding inner leads 3a. One of the bus bars 4a is provided with a projection 9a which is used for managing the metal wire lateral deflection amount. A position of the projection 9a is determined according to a later-described managing method.

In the semiconductor device thus structured, the lateral deflection of the metal wires 2a occurs upon resin filling. The metal wire 2a, whose lateral deflection amount becomes the greatest upon resin filling, extends perpendicularly to a resin inflow direction and is located near a resin inlet (not shown). Specifically, in Fig. 1, the lateral deflection amount of a metal wire 13a identified by a dotted line becomes the greatest. It is preferable to manage the lateral deflection amount of the metal wire 13a to be no greater than about 5% of a length of the metal wire. For example, in case of the length of the metal wire being 2mm, the metal wire lateral deflection amount is managed to be no greater than 0.1mm.

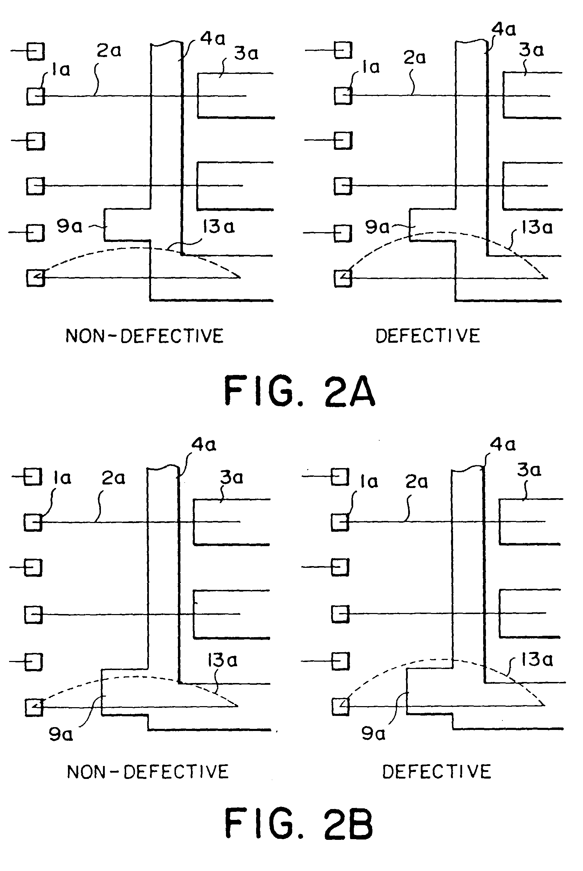

Fig. 2A shows an example of a managing method of the metal wire lateral deflection amount using the projection 9a shown in Fig. 1. In this method, if the metal wire 13a reaches the projection 9a upon resin filling, it is determined to be defective. In this case, the projection 9a is located at a position spacing 0.1mm from the metal wire 13a.

Fig. 2B shows a modification of the managing method shown in Fig. 2A. In this method, if the metal wire 13a exceeds a projection 9a upon resin filling, it is determined to be defective. In this case, the projection 9a extends to a position spacing 0.1mm from the metal wire 13a.

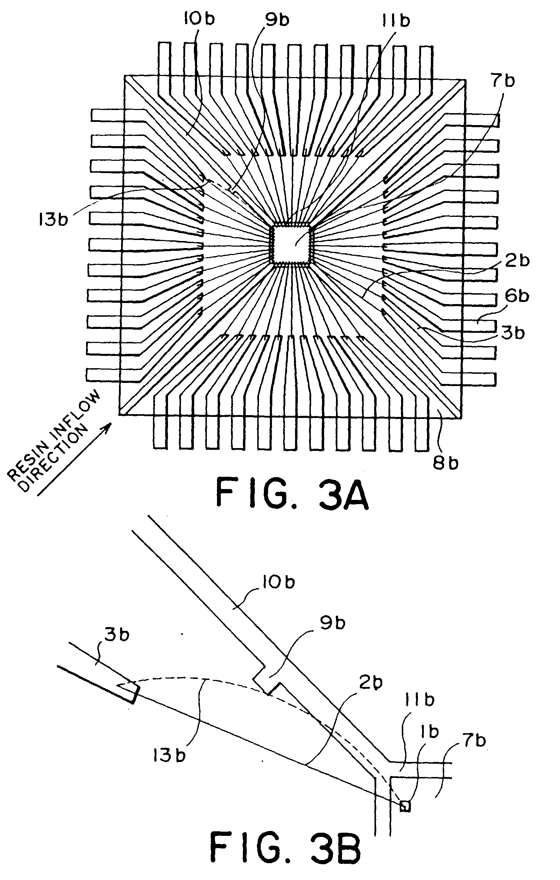

Fig. 3A shows a semiconductor device of a normal structure using no bus bar according to the second preferred embodiment of the present invention. Fig. 3B shows the main part of the semiconductor device shown in Fig. 3A on an enlarged scale.

Electrodes 1b are arranged along the peripheral edges of a semiconductor element 7b. The semiconductor element 7b is fixed on a semiconductor element mounting portion 11b Using a mount material (not shown) such as silver paste. The semiconductor element mounting portion 11b is connected to outer portions (not shown) of a lead frame by suspension pins 10b in the manner known in the art. Each of the suspension pins 10b has a width of about 0.2mm to 0.5mm. The electrodes 1b are connected to inner leads 3b via metal wires 2b, respectively. Each of the metal wires 2b is made of gold or an alloy of gold and has a diameter of about 20 µm to 30 µm. One of the suspension pins 10b is provided with a projection 9b which is used for managing the metal wire lateral deflection amount. The projection 9b is located at a position which can manage the metal wire lateral deflection amount within a given range.

The managing methods explained with reference to Figs. 2A and 2B can be carried out similarly using the projection 9b of the suspension pin 10b.

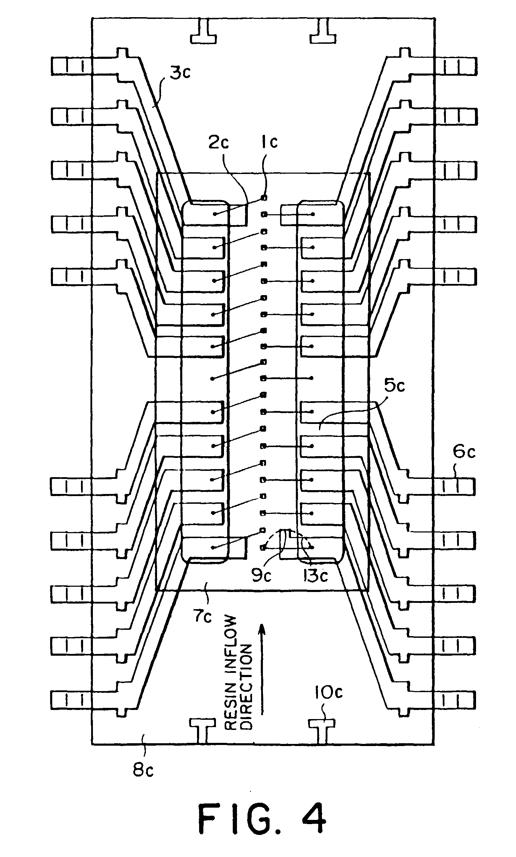

Fig. 4 shows a PKG of an LOG structure using no bus bar according to the third preferred embodiment of the present invention. Electrodes 1c are aligned at the center of a semiconductor element 7c. Tip portions of inner leads 3c are fixed on the semiconductor element 7c by adhesive tapes 5c made of polyimide or the like and having a thickness of about 0.05mm to 0.1mm. The electrodes 1c and the tip portions of the inner leads 3c are connected to each other via the metal wires 2c, respectively. Each metal wire 2c is made of gold or an alloy of gold and has a diameter of about 20 µm to 30 µm. One of the inner leads 3c is provided at its tip portion with a projection 9c which is used for managing the metal wire lateral deflection amount. The projection 9c is located at a position which can manage the metal wire lateral deflection amount within a given range.

The managing methods explained with reference to Figs. 2A and 2B can be carried out similarly using the projection 9c of the inner lead 3c.

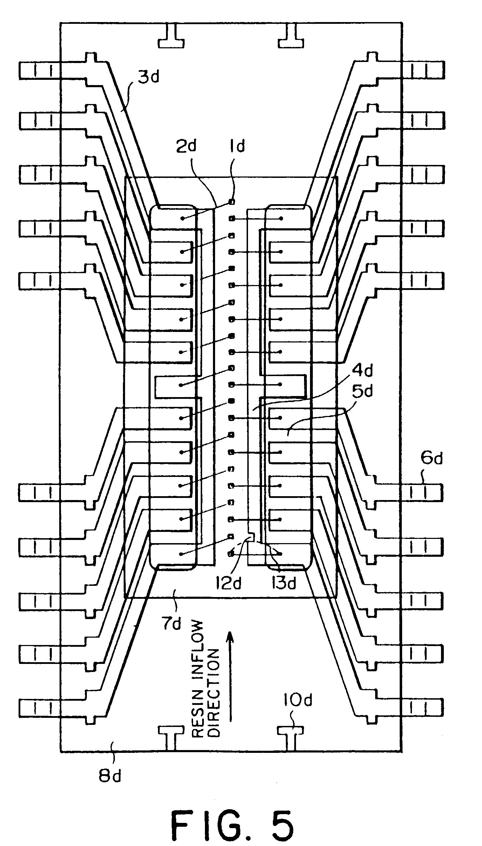

Fig. 5 shows a semiconductor device using the overlead bonding according to the fourth preferred embodiment of the present invention. Electrodes 1d are aligned at the center of a semiconductor element 7d. Tip portions of inner leads 3d are fixed on the semiconductor element 7d by adhesive tapes 5d made of polyimide or the like and having a thickness of about 0.05mm to 0.1mm. The electrodes 1d and the tip portions of the inner leads 3d are connected to each other via the metal wires 2d, respectively. Each metal wire 2d is made of gold or an alloy of gold and has a diameter of about 20 µm to 30 µm. Each of bus bars 4d is disposed between the electrodes 1a and the tip portions of the corresponding inner leads 3d. The metal wires 2d pass over the corresponding bus bars 4d. One of the bus bars 4d is provided with a cutout 12d which is used for managing the metal wire lateral deflection amount. A position of the cutout 12d is determined according to a later-described managing method.

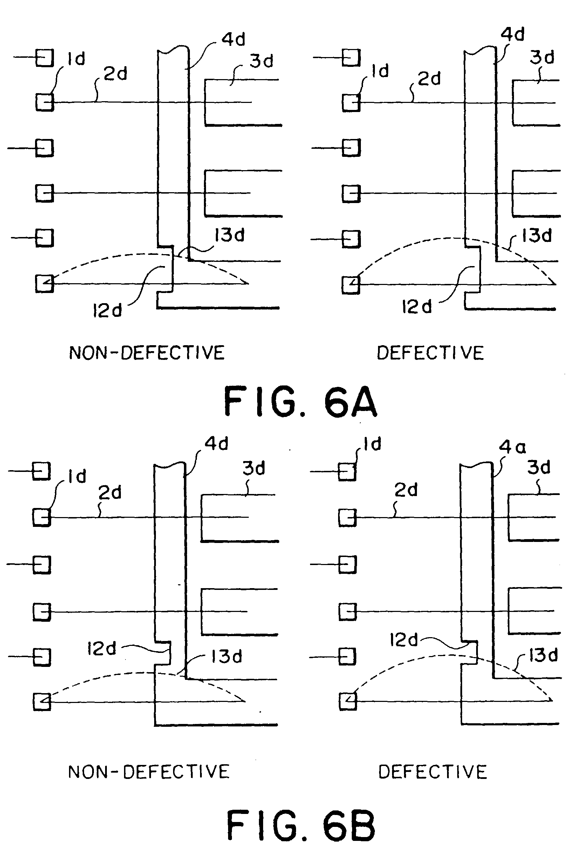

Fig. 6A shows an example of a managing method of the metal wire lateral deflection amount using the cutout 12d shown in Fig. 5. In this method, if the metal wire 13d reaches the cutout 12d upon resin filling, it is determined to be defective. In this case, the cutout 12d is located at a position spacing 0.1mm from the metal wire 13d.

Fig. 6B shows a modification of the managing method shown in Fig. 6A. In this method, if the metal wire 13d exceeds a cutout 12d upon resin filling, it is determined to be defective. In this case, the cutout 12d extends to a position spacing 0.1mm from the metal wire 13d.

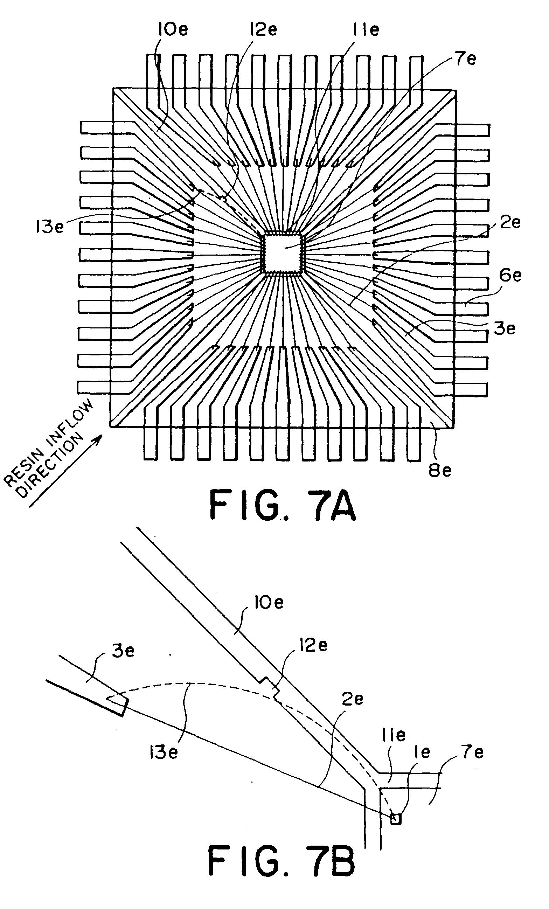

Fig. 7A shows a semiconductor device of a normal structure using no bus bar according to the fifth preferred embodiment of the present invention. Fig. 7B shows the main part of the semiconductor device shown in Fig. 7A on an enlarged scale.

Electrodes 1e are arranged along the peripheral edges of a semiconductor element 7e. The semiconductor element 7e is fixed on a semiconductor element mounting portion 11e using a mount material (not shown) such as silver paste. The semiconductor element mounting portion 11e is connected to outer portions (not shown) of a lead frame by suspension pins 10e each having a width of about 0.2mm to 0.5mm. The electrodes 1e are connected to inner leads 3e via metal wires 2e, respectively. Each of the metal wires 2e is made of gold or an alloy of gold and has a diameter of about 20 µm to 30 µm. One of the suspension pins 10e is provided with a cutout 12e which is used for managing the metal wire lateral deflection amount. The cutout 12e is located at a position which can manage the metal wire lateral deflection amount within a given range.

The managing methods explained with reference to Figs. 6A and 6B can be carried out similarly using the cutout 12e of the suspension pin 10e.

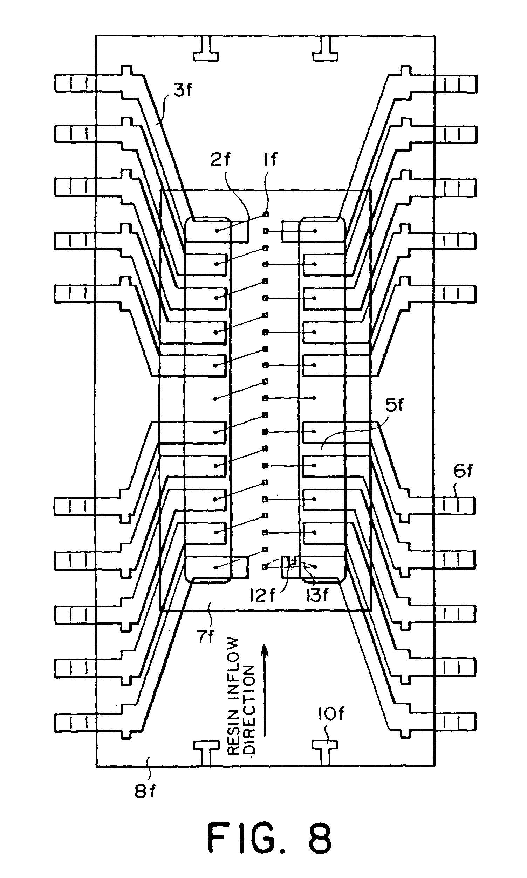

Fig. 8 shows a PXG of an LOG structure using no bus bar according to the sixth preferred embodiment of the present invention. Electrodes If are aligned at the center of a semiconductor element 7f. Tip portions of inner leads 3f are fixed on the semiconductor element 7f by adhesive tapes 5f made of polyimide or the like and having a thickness of about 0.05mm to 0.1mm. The electrodes 1f and the tip portions of the inner leads 3f are connected to each other via the metal wires 2f respectively. Each metal wire 2f is made of gold or an alloy of gold and has a diameter of about 20mm to 30mm. One of the inner leads 3f is provided at its tip portion with a cutout 12f which is used for managing the metal wire lateral deflection amount. The cutout 12f is located at a position which can manage the metal wire lateral deflection amount within a given range.

In Figs. 1-8, each of the projections 9a-9h and the cutouts 12a-12h serves as a managing arrangement which is for managing the lateral deflection amount of each of the metal wires 2a-2h.

The managing methods explained with reference to Figs. 6A and 6B can be carried out similarly using the cutout 12f of the inner lead 3f.

As described above, in the foregoing preferred embodiments, the determination between defective and non-defective is carried out based on whether the metal wire reaches or exceeds the projection or cutout. Therefore, the determination therebetween requires only a simple operation to enable the automatic management of the metal wire lateral deflection amount using an automatic recognition apparatus or the like.

As an example, the automatic management using the managing method shown in Fig. 6A will be explained.

Normally, in an image provided by an X-ray apparatus, portions made of metal, such as the metal wires and the inner leads, are displayed black since they do not transmit X-rays, while portions, such as the mold resin, the semiconductor element (silicon) and the adhesive tapes, are displayed white since they transmit X-rays. Specifically, the foregoing cutout is displayed white, while the metal wires are displayed black.

Accordingly, whether or not the metal wire 2d reaches the cutout 12d due to the metal wire lateral deflection can be automatically determined in the following manner: Specifically, after automatically recognizing a position of the cutout 12d (check area), the check area is two-valued with white and black. Then, it is automatically determined to be defective if black (metal wire) is detected in the check area, and non-defective if black is not detected in the check area.

As described above, the lead frame is provided with the projection or cutout which is used for managing the metal wire lateral deflection, so that it can be easily judged without measuring the metal wire lateral deflection amount whether the amount is within a given range, that is, whether the amount is above the standards. This makes it possible to shorten a check time and carry out the automatic management using the automatic recognition apparatus or the like.

A skilled person readily recognizes that modifications may be made to the specific embodiments described herein-before, such as providing a cutout instead of a projection as mentioned, or, providing a combination of both features. Similarly, other features described in connection with different embodiments may be combined to form a new embodiment. One embodiment of the present invention may be summarized as follows.

In a semiconductor device, a bus bar (4a) is provided with a projection (9a). Based on a positional relationship between the projection and a metal wire (13a) subjected to the lateral deflection upon resin filling, the metal wire lateral deflection amount is managed. The projection may be provided on a suspension pin or at another portion of a lead frame. A cutout may be provided instead of the projection.

## Claims

1. A lead frame for use in a semiconductor device comprising a semiconductor element and a metal wire which is connected between said semiconductor element and said lead frame, characterized in that said lead frame comprises managing means for managing a lateral deflection amount of said metal wire.

2. A lead frame as claimed in claim 1, further comprising a bus bar, said managing means comprising a projection formed to said bus bar.

3. A lead frame as claimed in claim 1, further comprising a suspension pin, said managing means comprising a projection formed to said suspension pin.

4. A lead frame as claimed in claim 1, wherein said managing means comprises a projection formed to a portion of said lead frame.

5. A lead frame as claimed in claim 1, further comprising a bus bar, said managing means comprising a cutout made to said bus bar.

6. A lead frame as claimed in claim 1, further comprising a suspension pin, said managing means comprising a cutout made to said suspension pin.

7. A lead frame as claimed in claim 1, wherein said managing means comprises a cutout made to a portion of said lead frame.

8. A semiconductor device comprising a semiconductor element, a lead frame, and a metal wire which is connected between said semiconductor element and said lead frame, characterized in that said lead frame comprises managing means for managing a lateral deflection amount of said metal wire.

9. A semiconductor device as claimed in claim 8, wherein said lead frame further comprises a bus bar, said managing means comprising a projection formed to said bus bar.

10. A semiconductor device as claimed in claim 8, wherein said lead frame further comprises a suspension pin, said managing means comprising a projection formed to said suspension pin.

11. A semiconductor device as claimed in claim 8, wherein said managing means comprises a projection formed to a portion of said lead frame.

12. A semiconductor device as claimed in claim 8, wherein said lead frame further comprises a bus bar, said managing means comprising a cutout made to said bus bar.

13. A semiconductor device as claimed in claim 8, wherein said lead frame further comprises a suspension pin, said managing means comprising a cutout made to said suspension pin.

14. A semiconductor device as claimed in claim 8, wherein said managing means comprises a cutout made to a portion of said lead frame.

15. A managing method of managing a metal wire connected between a semiconductor element and a lead frame which are included in a semiconductor device,
characterized in that said method comprises the steps of:
providing managing means at a portion of said lead frame; and
managing a lateral deflection amount of said metal wire by the use of said managing means.

16. A managing method as claimed in claim 15, wherein said method further comprises a step of automating the managing step by the use of an automatic recognition apparatus.

17. A managing method as claimed in claim 15, wherein said managing means comprises a projection formed to said portion of the lead frame.

18. A managing method as claimed in claim 15, wherein said managing means comprises a cutout made to said portion of the lead frame.
